# EUROPÄISCHE PATENTSCHRIFT

(11) **EP 2 754 340 B1**
(45) Veröffentlichungstag und Bekanntmachung des Hinweises auf die Patenterteilung: **10.03.2021**
(21) Anmeldenummer: 12805562.1
(22) Anmeldetag: 01.09.2012
(51) Int. Cl.: H05K 3/20, H05K 1/02, H05K 3/34, H01R 12/55, H05K 3/40, H05K 3/30, E05B 85/02, E05B 81/54, E05B 81/06

(54) **SCHLOSS FÜR EIN KRAFTFAHRZEUG MIT EINER LEITERBAHNEINHEIT**
LOCK FOR A MOTOR VEHICLE WITH A CONDUCTOR TRACK UNIT
SERRURE POUR UN VÉHICULE À MOTEUR AVEC UNE UNITÉ À TRACÉS CONDUCTEURS

(30) Priorität: 05.09.2011 DE 102011082140
(43) Veröffentlichungstag der Anmeldung: 16.07.2014
(73) Patentinhaber: Kiekert Aktiengesellschaft, 42579 Heiligenhaus (DE)
(72) Erfinder: GÖTZEN, Klaus, 45481 Mülheim (DE)
(74) Vertreter: Andrejewski - Honke Patent- und Rechtsanwälte Partnerschaft mbB
(86) Internationale Anmeldenummer: PCT/DE2012/000879
(87) Internationale Veröffentlichungsnummer: WO 2013/034128

(56) Entgegenhaltungen:
- EP-A2- 0 260 681
- DE-A1- 2 723 201
- DE-A1-102005 049 975
- DE-A1-102009 036 128
- US-A1- 2004 048 524
- US-A1- 2010 065 962

## Beschreibung

Die Erfindung betrifft ein Schloss für ein Kraftfahrzeug mit einer Leiterbahneinheit mit in einem elektrisch isolierenden Material eingebetteten Leiterbahnen und mit den Leiterbahnen elektrisch verbundenen, von außen zugänglichen elektrischen Anschlüssen, wobei die Leiterbahnen vollständig oder überwiegend aus Stahl oder Weißblech bestehen.

An die elektrischen Anschlüsse einer solchen Leiterbahneinheit werden elektrische oder elektronische Komponenten angeschlossen, wie zum Beispiel Schalter, Detektoren oder Elektromotoren. Derartige elektrische Komponenten finden sich beispielsweise in einem Schloss, insbesondere Türschloss eines Kraftfahrzeugs. Ein Schloss für Kraftfahrzeug im Sinne der vorliegenden Erfindung umfasst grundsätzlich eine Drehfalle und wenigstens eine Sperrklinke, mit der eine Drehung der Drehfalle in Öffnungsrichtung blockiert werden kann.

Aus der Druckschrift DE 10 2005 049 975 A1 ist eine Leiterbahneinheit bekannt, die aus Weißblech gestanzte Leiterbahnen umfasst. Die Leiterbahnen führen aus einem Basiselement heraus. Ein solches Basiselement besteht üblicherweise aus einem elektrisch isolierenden Material und zwar insbesondere aus Kunststoff. Herausgeführte Teile der Leiterbahnen stellen von außen zugängliche elektrische Anschlüsse dar. Mit diesen können Kontakte von elektrischen oder elektronischen Komponenten verbunden werden.

Leiterbahnfolien in Kunststoff einzubetten, ist aus der Druckschrift EP 1 231 824 A2 bekannt. Zu diesem Zweck werden Leiterbahnen mit Kunststoff umspritzt.

Der Kunststoff umfasst Fenster, die eine elektrische Kontaktierung der Leiterbahnenfolie ermöglichen.

Aus der Druckschrift EP 1 527 967 B1 geht eine Leiterbahneinheit hervor, die Leiterbahnen mit umgebogenen Endabschnitten umfasst. Solche umgebogenen Endabschnitte können als elektrische Anschlüsse dienen, die gegenüber einem elektrisch isolierenden Material hervorstehen. Die Anschlüsse können mit elektrischen oder elektronischen Komponenten entsprechend verbunden werden.

Im gattungsbildenden Stand der Technik nach der DE 10 2009 036 128 A1 geht es um eine elektrische Komponente eines Kraftfahrzeuges in einem Kunststoffgehäuse. In das Kunststoffgehäuse wird eine Leiterbahnstruktur im Spritzgießverfahren zumindest zu einem wesentlichen Teil eingebettet. Die Leiterbahnstruktur weist Drähte aus Materialien wie Kupfer, Eisen, Stahl oder dergleichen auf. Auf diese Weise soll insgesamt die konstruktive Freiheit erhöht und die Fertigkeit optimiert werden. Mechanische Probleme werden nicht angesprochen.

Durch die US 2004/0048524 A1 ist eine Leiterbahnstruktur bekannt geworden, die unter anderem mit Leiterbahnen auf Aluminiumbasis und zusätzlichen elektrischen Anschlüssen auf der Basis von Kupfer arbeitet. Auch die isolierende Einbettung wird angesprochen.

Wie der Druckschrift DE 10 2005 049 975 A1 zu entnehmen ist, sind die Anforderungen an eine Leiterbahneinheit bei einer Verwendung in einem Kraftfahrzeug sehr hoch. Solche Leiterbahneinheiten sind im Fall eines Kraftfahrzeugs problematischen Umgebungsbedingungen insbesondere in Bezug auf Temperatur, Luftfeuchtigkeit, Verschmutzung sowie mechanischen Stößen und Vibrationen ausgesetzt. Vor diesem Hintergrund ist es Aufgabe der Erfindung, eine Leiterbahneinheit bereitzustellen, die solchen problematischen Umgebungsbedingungen sehr gut gewachsen ist.

Zur Lösung der Aufgabe wird ein Schloss für ein Kraftfahrzeug mit einer Leiterbahneinheit mit den Merkmalen des Anspruchs 1 bereitgestellt. Vorteilhafte Ausgestaltungen ergeben sich aus den Unteransprüchen.

Die Leiterbahneinheit mit den Merkmalen des Anspruchs 1 ist mit in einem elektrisch isolierenden Material eingebetteten Leiterbahnen versehen. Die Leiterbahnen sind erfindungsgemäß vollständig vom elektrisch isolierenden Material umgeben und sind daher nicht von außen zugänglich. Elektrische Anschlüsse sind mit den Leiterbahnen elektrisch verbunden. Die elektrischen Anschlüsse sind von außen zugänglich, so dass diese mit elektrischen Kontakten von elektrischen oder elektronischen Bauteilen wie Schalter, Detektor, elektronisches Funkbauteil, integrierter Schaltkreis, elektronischer Chip, elektronische Steuereinrichtung oder Motor beispielsweise durch Löten elektrisch verbunden werden können. Die Leiterbahnen und elektrischen Anschlüsse sind verschiedene Bauteile, die also zunächst voneinander unabhängig sind und voneinander unabhängig hergestellt werden können. Diese Trennung ermöglicht es, die besonders empfindlichen Anschlüsse aus einem Material herzustellen, welches den eingangs genannten hohen Anforderungen besonders gut gewachsen ist, ohne deshalb auch die Leiterbahnen aus diesem Material herstellen zu müssen. Da die Leiterbahnen in dem elektrisch isolierenden Material eingebettet sind und nicht nachträglich kontaktiert werden müssen, unterscheiden sich die Anforderungen an die Leiterbahnen von den Anforderungen, die an die elektrischen Anschlüsse gestellt werden. Es kann daher für die elektrischen Anschlüsse ein Material oder aber auch eine Materialstärke ausgewählt werden, welches bzw. welche den Anforderungen besonders gut gewachsen ist, die an die Leiterbahnen gestellt werden. Obwohl die Zahl der Teile im Vergleich zu einer einteiligen Bauweise von Leiterbahn und Anschluss erhöht worden ist, hat sich überraschenderweise herausgestellt, dass mit insgesamt dennoch geringem technischen Herstellungsaufwand eine Leiterbahneinheit bereitgestellt werden kann, die den eingangs genannten Anforderungen besonders gut gewachsen ist.

Die Leiterbahnen bestehen zur Lösung der Aufgabe vorzugsweise zumindest überwiegend oder vollständig aus einem anderen Material als die elektrischen Anschlüsse. Den jeweiligen Anforderungen entsprechend kann daher ein besonders gut geeignetes Material ausgewählt werden. Die elektrischen Anschlüsse bestehen in einer Ausführungsform daher überwiegend oder vollständig aus Messing. Andere elektrisch leitfähige Materialien wie zum Beispiel Kupfer oder Kupfer mit einer Goldbeschichtung sind möglich. Die Leiterbahnen bestehen in einer Ausführungsform vollständig oder überwiegend aus mechanisch besonders belastbarem Stahl oder Eisen, besonders bevorzugt aber aus Weißblech, also einem dünnen kaltgewalzten Stahl, dessen Oberfläche mit Zinn beschichtet wurde. Die Materialstärke, also die Wanddicke des Stahls beträgt bevorzugt wenigstens 0,05 mm und/ oder nicht mehr als 0,5 mm. Eine Stahloberfläche ist mit sehr geringer Menge an Zinn beschichtet, beispielsweise mit wenigen Gramm pro Quadratmeter, so zum Beispiel mit wenigstens 1 g/m2 und/ oder nicht mehr als 5 g/m2. Die Zinnschicht ist bevorzugt weniger als 1 µm dick, besonders bevorzugt weniger als 0,5 µm dick.

Durch die Zinnschicht bewirkt eine Leiterbahn weiter verbessert vor negativen Beeinträchtigungen wie Korrosion geschützt. Zum Korrosionsschutz trägt zusätzlich die Ummantelung aus elektrisch isolierendem Material bei.

Die Leiterbahnen sind vorzugsweise durch eine Passung, in der Regel eine Presspassung oder auf andere Weise klemmend mit den elektrischen Anschlüssen elektrisch verbunden. Der Fertigungsaufwand kann so gering gehalten werden. Dennoch ist es möglich, die Anschlüsse mit den Leiterbahnen derart zuverlässig zu verbinden, dass diese Verbindungen den eingangs genannten Anforderungen gewachsen sind. In Betracht kommen aber auch alternativ oder ergänzend andere Verbindungen wie Lötverbindungen.

Erfindungsgemäß sind die Verbindungen zwischen Leiterbahn und elektrischem Anschluss ebenfalls im elektrisch isolierenden Material vollständig eingebettet, was weiter verbessert dazu beiträgt, dass die Verbindungen den eingangs genannten Anforderungen sehr gut gewachsen sind.

Die elektrischen Anschlüsse sind in einer Ausführungsform mit Vorsprüngen und/oder Hinterschneidungen versehen, die sich im elektrisch isolierenden Material befinden. Hierdurch wird weiter verbessert erreicht, dass die Anschlüsse besonders zuverlässig gehalten werden. Insgesamt ist die Leiterbahneinheit dann weiter verbessert den eingangs genannten Anforderungen besonders gut gewachsen.

Die elektrischen Anschlüsse sind in einer Ausführungsform bis zu einem Anschlag in Ausnehmungen der Leiterbahnen hinein gesteckt. Hierdurch gelingt es weiter verbessert, den Montageaufwand gering zu halten. Auch wird zuverlässig und genau die zutreffende Position der elektrischen Anschlüsse relativ zu den Leiterbahnen eingehalten.

Die elektrischen Anschlüsse schließen vorzugsweise einen rechten Winkel mit daran angrenzenden Leiterbahnbereichen ein. Eine Mehrzahl von Anschlüssen können dann regelmäßig von nur einer Seite aus kontaktiert werden, was den Montageaufwand weiter verbessert gering hält.

Das elektrisch isolierende Material besteht bevorzugt aus einem mit Glasfasern (GF) verstärkten thermoplastischen Kunststoff, besonders bevorzugt aus Polybutylenterephthalat (PBT). Insbesondere wird PBT-GF 20 verwendet, also ein thermoplastisches Kunststoffmaterial mit einem Anteil von 20 % Glasfasern. Einerseits lässt sich ein solches thermoplastisches Material leicht verarbeiten, was den Fertigungsaufwand gering hält. Glasfasern tragen weiter verbessert dazu bei, dass die Leiterbahneinheit den eingangs genannten Belastungen besonders gut gewachsen ist.

Die Leiterbahnen sind vorzugsweise durch ein Stanzgitter gebildet. Der Fertigungsaufwand wird dadurch weiter verbessert gering gehalten.

Die Leiterbahneinheit ist insbesondere Teil eines Schlosses für ein Kraftfahrzeug oder auf andere Weise Teil eines Kraftfahrzeugs.

Es zeigen
- Fig. 1:: Schnitt durch eine erste Ausführungsform
- Fig. 2:: Schnitt durch eine zweite Ausführungsform
- Fig. 3:: Leiterbahneinheit mit angeschlossenem Elektromotor
- Fig. 4: Schlossgehäuseanteil

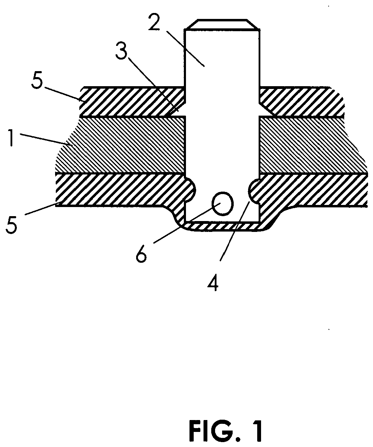

Die Figur 1 zeigt im Schnitt eine zum Beispiel 0,3 mm dicke Leiterbahn 1, die aus Weißblech besteht. In eine Bohrung, die durch die Leiterbahn 1 hindurchführt, ist ein elektrischer Anschluss 2 hineingesteckt und zwar bis zu einem Anschlag 3. Der Anschluss 2 ist über eine Presspassung mit der Leiterbahn 1 verbunden und kontaktiert daher zuverlässig und dauerhaft elektrisch die Leiterbahn 1. Der elektrische Anschluss 2 weist eine Grundform auf, die zylinderförmig und daher mechanisch besonders stabil ist. Eine derartige rotationssymmetrische Form trägt weiter verbessert dazu bei, dass die Leiterbahneinheit vor allem auch den mechanischen Belastungen zuverlässig gewachsen ist. Der optional vorgesehene Anschlag 3 des Anschlusses 2 umringt die Zylinder förmige Grundform und ist im Querschnitt in einer Ausgestaltung derart dreiecksförmig, dass eine Seite des Rechteckes planparallel auf der Oberfläche der Leiterbahn 1 aufzuliegen vermag. Die Grundform des Anschlusses 2 ist durch die Leiterbahn hindurch gesteckt. Das hindurch gesteckte Ende des Anschlusses 2 weist beispielsweise eine umlaufende Nut 4 mit einem beispielsweise halbkreisförmigen Querschnitt auf.

Die Leiterbahn 1 sowie die Verbindung zwischen dem Anschluss 2 und der Leiterbahn 1 sind in einem Kunststoff 5 vollständig eingebettet bzw. mit einem Kunststoff 5 vollständig umspritzt. Lediglich das in der Figur 1 oben gezeigte Ende des Anschlusses 2 steht gegenüber dem Kunststoff 5 hervor und ist daher von außen zugänglich. Der Kunststoff trägt also zum Schutz der Verbindung bei.

Der Anschluss 2 besteht bevorzugt aus Messing und ist aufgrund seiner Zylinderform mechanisch besonders gut belastbar. Es kommen aber auch andere rotationssymmetrische Grundformen in Betracht. Auch rechteckige oder quadratische Querschnitte sind möglich. Der Kunststoff besteht bevorzugt aus PBT und ist mit Glasfasern verstärkt, um die Leiterbahn 1 nicht nur vor Feuchtigkeit und Schmutz zu schützen, sondern auch vor mechanischer Belastung. Als Kunststoff wird beispielsweise PBT-GF 20 oder PBT-GF 30 eingesetzt.

Der Kunststoff 5 reicht in die Nut 4 hinein und überdeckt außerdem den Anschlag 3. Der Kunststoff 5 trägt so dazu bei, dass der Anschluss 2 sehr stabil und besonders dauerhaft gehalten ist. Nur der Bereich ist zugänglich, der für ein Verbinden mit einem elektrischen Kontakt eines elektrischen oder elektronischen Bauteils erforderlich ist.

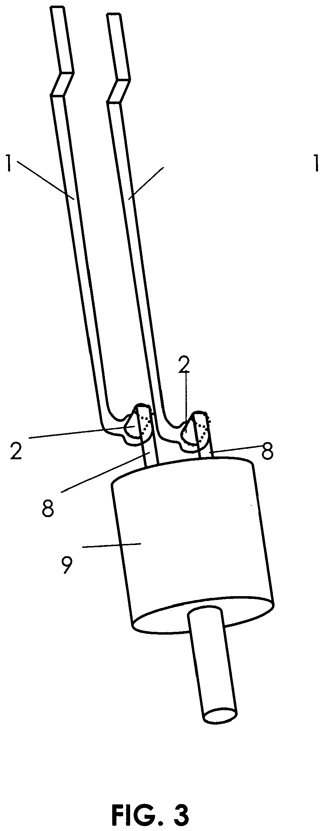

Eine Leiterbahneinheit umfasst eine Mehrzahl von Leiterbahnen 1 und eine Mehrzahl von Anschlüssen 2, die beispielsweise wie in der Figur 1 gezeigt beschaffen sind. Vorzugsweise dienen die Kontakte zum Kontaktieren eines elektrischen Zentralverriegelungsantriebs, beispielsweise eines Motors einer Zentralverriegelung in einem Tür- oder Klappenschloss eines Kraftfahrzeugs. Im montierten Zustand ist die Leiterbahneinheit also mit den entsprechenden Kontakten eines elektrischen Zentralverriegelungsantriebs verbunden, beispielsweise verlötet, wie dies in der Figur 3 beispielhaft gezeigt wird.

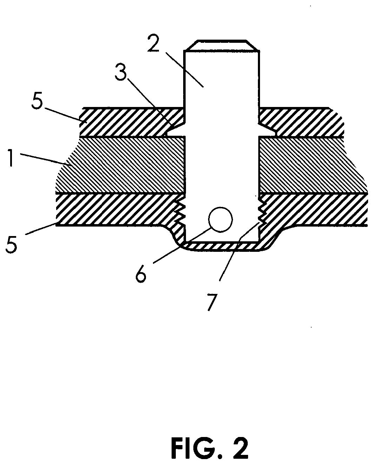

Alternativ oder ergänzend zu der halbkreisförmigen Nut 4 kann der Anschluss 2 mit ein oder mehreren Bohrungen 6 versehen sein, in die Kunststoffmaterial 5 hineinreicht bzw. hineinreichen. Alternativ oder ergänzend kann die zylinderförmige Mantelfläche zumindest teilweise mit einem Gewinde oder einer Riffelung 7 wie in der Figur 2 gezeigt versehen sein, die in das Kunststoffmaterial hineinreicht, um für einen zuverlässigen Halt zu sorgen.

Der Anschlag 3 muss im Schnitt nicht zwingend dreiecksförmig sein. So kann die außen liegende Kante abgeflacht sein oder beispielsweise durch eine senkrecht verlaufende Wand ersetzt sein, wie dies in der Figur 2 gezeigt wird. Auch andere Formen von Hinterschneidungen, Ausnehmungen, Einkerbungen oder vorstehenden Nasen sind möglich, um für einen guten Halt im Kunststoffmaterial zu sorgen.

Durch die Erfindung kann eine besonders robuste und dennoch filigrane Leiterbahneinheit bereitgestellt werden.

Die Figur 3 zeigt zwei Leiterbahnen 1 eines Stanzgitters. Eine Einbettung der Leiterbahnen 1 in einen Kunststoff wurde in der Figur 3 nicht dargestellt, um den Blick auf die Leiterbahnen 1 freizugeben. Zwei elektrische Anschlüsse 2 sind mit Endbereichen der Leiterbahnen 1 durch je eine Pressefassung mit den Leiterbahnen 1 fest verbunden. Elektrische Kontakte 8 eines Elektromotors 9 sind mit den Anschlüssen 2 verlötet. Der Elektromotor 9 ist insbesondere Teil einer Zentralverriegelung. Anstelle eines Elektromotors kann auch ein Stellantrieb vorgesehen sein, der einen Riegel zwischen zwei unterschiedlichen Stellungen hin und zurück zu bewegen vermag. Ein solcher Stellantrieb kann ebenfalls Teil eines Schlosses für ein Kraftfahrzeug sein.

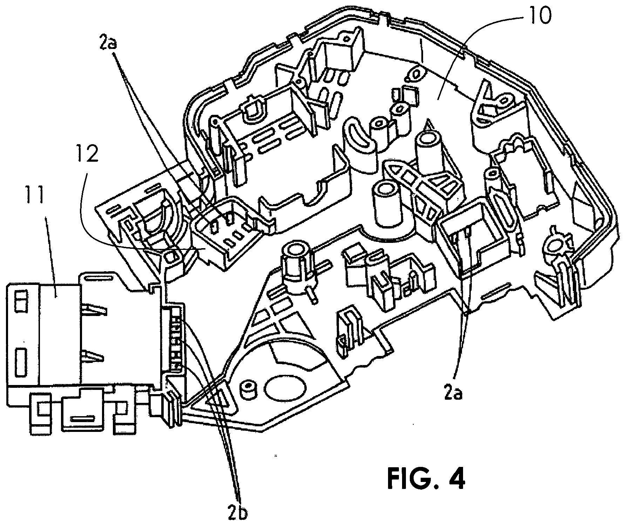

Die Figur 4 zeigt die Innenseite eines Schlossgehäuseteils 10 mit von außen eingelegten Leiterbahnen, die in Form eines Stanzgitters vorliegen. Außen sind die Leiterbahnen sowie die Verbindungen zwischen den Leiterbahnen und den Anschlüssen in dem elektrisch isolierenden Materialvollständig eingebettet. Durch Durchgänge im Schlossgehäuseteil 10 hindurch reichen die elektrischen Anschlüsse der Leiterbahnen einer erfindungsgemäßen Leiterbahneinheit, so dass sich Endbereiche 2a, 2b von elektrischen Anschlüssen der Leiterbahneinheit wie dargestellt im Inneren des Schlossgehäuseteils 10 befinden. Diese Enden 2a, 2b werden bei Bedarf mit entsprechenden elektrischen, elektromechanischen oder elektronischen Bauteilen verbunden. Enden 2b von Anschlüssen, die durch eine Passung mit auf der nicht sichtbaren Rückseite des Schlossgehäuseteils 10 befindlichen Leiterbahnen elektrisch verbunden sind, ragen nahe beim entsprechenden Gehäuserand durch die angrenzende Wand hindurch, um mit einem Anschlussstecker 11 geeignet verbunden zu werden. Die Enden 2a und 2b werden mit elektrischen Anschlüssen von Steckern und anderen elektrischen, elektromechanischen oder elektronischen Komponenten insbesondere verlötet, um zuverlässige elektrische Verbindungen zu schaffen. Abschließend können Lagerstätten für elektrische oder elektronische Komponenten, die beispielsweise durch senkrecht von der Rückwand abstehende Wandungen 12 begrenzt werden, mit einer elektrisch isolierenden Vergussmasse ausgegossen, umso die elektrischen Verbindungen ergänzend vor äußeren Einflüssen zu schützen. Anstelle einer Vergussmasse kann aber auch eine isolierende Masse in Lagerstätten beispielsweise hineingedrückt werden. Durch senkrechte Wandungen 12 wird erreicht, dass schnell und zuverlässig eine isolierende Vergussmasse in einen vorgegebenen Raum gegossen werden kann, um die gewünschte Abschirmung zu erhalten. In ähnlicher Weise können die Leiterbahnen auf der Rückseite vor äußeren Einflüssen geschützt worden sein. Durch das Vergießen gelingt auch eine mechanische Fixierung. Die Leiterbahnen können aber auch innen in ein Gehäuseteil 10 eingelegt und in eine Vergussmasse eingebettet sein.

Anstelle einer Vergussmasse kann aber auch eine geeignet isolierende Masse beispielsweise in den Raum bzw. in die Form hineingedrückt werden. Ohne großen technischen Aufwand betreiben zu müssen, steht so ein Schlossgehäuseteil 10 mit elektrischen Verbindungen und elektrischen Leitungen bereit, die dauerhaft und elektrisch nach außen abgeschirmt sind.

Das beschriebene Schlossgehäuseteil 10 kann einstückig durch Spritzguss hergestellt werden und besteht daher vorzugsweise aus einem geeigneten thermoplastischen Kunststoffmaterial wie PE.

Nach dem Einbau der gewünschten Komponenten und Bauteile kann das Schlossgehäuseteil 10 mit einem weiteren Schlossgehäuseteil oder einer Platte verschlossen werden, um so ein gewünschtes Schloss für ein Kraftfahrzeug bereitzustellen. Insbesondere handelt es sich bei einer dieser Komponenten, die elektrisch mit Enden 2a verbunden ist, um einen Elektromotor oder Stellantrieb einer Zentralverriegelung des Schlosses.

Nicht sämtliche elektrischen Anschlüsse einer solchen erfindungsgemäßen Leiterbahneinheit müssen in anspruchsgemäßer Weise ausgestaltet sein. Eine erfindungsgemäße Leiterbahneinheit kann also zusätzlich zu den anspruchsgemäßen Anschlüssen weitere Anschlüsse umfassen, die einteilig mit den Leiterbahnen verbunden sind. Solche einteilig verbundenen Anschlüsse können in Form von umgebogenen Enden vorliegen. In Abhängigkeit von der individuellen Belastungssituation im eingebauten Zustand werden dann Anschlüsse einteilig ausgeführt oder aber in anspruchsgemäßer Weise zweiteilig.

### Bezugszeichenliste

- 1:: Leiterbahn
- 2:: elektrischer Anschluss
- 2a, 2b:: elektrisches Anschlussende
- 3:: Anschlag
- 4:: Nut
- 5:: Kunststoffummantelung
- 6:: Bohrung
- 7:: Riffelung
- 8:: Kontakt eines Elektromotors
- 9:: Elektromotor
- 10:: Schlossgehäuseteil
- 11:: Stecker
- 12:: Wandung

## Patentansprüche

1. Schloss für ein Kraftfahrzeug mit einer Leiterbahneinheit mit in einem elektrisch isolierenden Material (5) eingebetteten Leiterbahnen (1) und mit den Leiterbahnen (1) elektrisch verbundenen, von außen zugänglichen elektrischen Anschlüssen (2), wobei die Leiterbahnen (1) vollständig oder überwiegend aus Stahl oder Weißblech bestehen, **dadurch gekennzeichnet, dass**
- die Leiterbahnen (1) und elektrischen Anschlüsse (2) verschiedene Bauteile sind, und dass
- die Leiterbahnen (1) zumindest überwiegend aus einem anderen Material bestehen als die elektrischen Anschlüsse (2), wobei
- das elektrisch isolierende Material (5) aus einem mit Glasfasern verstärkten Kunststoff besteht, und wobei
- die jeweilige Leiterbahn (1) sowie die Verbindung zwischen dem Anschluss (2) und der Leiterbahn (1) in den Kunststoff (5) vollständig eingebettet sind.

2. Schloss nach Anspruch 1, **dadurch gekennzeichnet, dass** die elektrischen Anschlüsse (2) überwiegend oder vollständig aus Messing bestehen.

3. Schloss nach Anspruch 1 oder 2, **dadurch gekennzeichnet, dass** die Leiterbahnen (1) durch eine Passung, vorzugsweise Presspassung und/oder klemmend mit den elektrischen Anschlüssen (2) elektrisch verbunden sind.

4. Schloss nach einem der Ansprüche 1 bis 3, **dadurch gekennzeichnet, dass** die elektrischen Anschlüsse (2) mit Vorsprüngen, Nuten (4), Riffelungen (7) und/oder Hinterschneidungen versehen sind, die an das elektrisch isolierende Material (5) angrenzen.

5. Schloss nach einem der Ansprüche 1 bis 4, **dadurch gekennzeichnet, dass** die elektrischen Anschlüsse (2) bis zu einem Anschlag (3) in Ausnehmungen oder Bohrungen der Leiterbahnen (1) hinein gesteckt sind.

6. Schloss nach einem der Ansprüche 1 bis 5, **dadurch gekennzeichnet, dass** die elektrischen Anschlüsse (2) einen rechten Winkel mit daran angrenzenden Leiterbahnbereichen (1) einschließen.

7. Schloss nach einem der Ansprüche 1 bis 6, **dadurch gekennzeichnet, dass** es sich bei dem Kunststoff (5) um einen thermoplastischen Kunststoff, besonders bevorzugt aus Polybutylenterephthalat (PBT) handelt.

8. Schloss nach einem der Ansprüche 1 bis 7, **dadurch gekennzeichnet, dass** die Leiterbahnen (1) durch ein Stanzgitter gebildet sind.

## Claims

1. Lock for a motor vehicle, having a conducting path unit with conducting paths (1) which are embedded in an electrically insulating material (5), and with electrical connectors (2) which are electrically connected to the conducting paths (1) and accessible from the outside, wherein the conducting paths (1) consist entirely or mostly of steel or tinplate, **characterized in that**
- the conducting paths (1) and electrical connectors (2) are different components, and that
- the conducting paths (1) consist at least mainly of a different material from that of the electrical connectors (2), wherein
- the electrically insulating material (5) consists of a glass fibre-reinforced plastic, and wherein
- the respective conducting path (1) and the connection between the connector (2) and the conducting path (1) are completely embedded in the plastic (5).

2. Lock according to Claim 1, **characterized in that** the electrical connectors (2) are made mostly or entirely of brass.

3. Lock according to Claim 1 or 2, **characterized in that** the conducting paths (1) are electrically connected to the electrical connectors (2) by a fit element, preferably a press fit element, and/or by clamping.

4. Lock according to any one of Claims 1 to 3, **characterized in that** the electrical connectors (2) are furnished with projections, grooves (4), flutings (7) and/or undercuts which are adjacent to the electrically insulating material (5).

5. Lock according to any one of Claims 1 to 4, **characterized in that** the electrical connectors (2) are inserted in recesses or boreholes in the conducting paths (1) as far as a limit stop (3).

6. Lock according to any one of Claims 1 to 5, **characterized in that** the electrical connectors (2) form a right angle with adjacent conducting path regions (1) .

7. Lock according to any one of Claims 1 to 6, **characterized in that** the plastic (5) is a thermoplastic plastic, particularly preferably made of polybutylene terephthalate (PBT).

8. Lock according to any one of Claims 1 to 7, **characterized in that** the conducting paths (1) are created by a stamping grid.

## Revendications

1. Serrure pour un véhicule automobile avec une unité de circuits imprimés avec des circuits imprimés (1) incorporés dans un matériau électriquement isolant (5) et avec des connexions (2) électriques reliées électriquement aux circuits imprimés (1) accessibles de l'extérieur, sachant que les circuits imprimés (1) sont complètement ou essentiellement composés d'acier ou de fer-blanc,
**caractérisée en ce que**
- les circuits imprimés (1) et les connexions électriques (2) sont des composants différents et **en ce que**
- les circuits imprimés (1) sont composés au moins essentiellement d'un autre matériau que les connexions électriques (2), sachant que
- le matériau électriquement isolant (5) est composé d'une matière plastique renforcée aux fibres de verre et sachant que
- le circuit imprimé respectif (1) ainsi que la liaison sont complètement incorporés dans la matière plastique (5) entre la connexion (2) et le circuit imprimé (1).

2. Serrure selon la revendication 1, **caractérisée en ce que** les connexions électriques (2) sont essentiellement ou complètement composés de laiton.

3. Serrure selon la revendication 1 ou 2, **caractérisée en ce que** les circuits imprimés (1) sont reliés électriquement aux connexions électriques (2) par un ajustage, de préférence un ajustage serré et/ou par serrage.

4. Serrure selon l'une quelconque des revendications 1 à 3, **caractérisée en ce que** les connexions électriques (2) sont dotées de saillies, de rainures (4), de cannelures (7) et/ou de dépouilles, qui sont adjacentes au matériau électriquement isolant (5).

5. Serrure selon l'une quelconque des revendications 1 à 4, **caractérisée en ce que** les connexions électriques (2) sont enfichées jusqu'à une butée (3) dans des évidements ou des trous des circuits imprimés (1).

6. Serrure selon l'une quelconque des revendications 1 à 5, **caractérisée en ce que** les connexions électriques (2) forment un angle droit avec des zones de circuits imprimés (1) limitrophes de celles-ci.

7. Serrure selon l'une quelconque des revendications 1 à 6, **caractérisée en ce que** concernant la matière plastique (5), il s'agit d'une matière thermoplastique, en particulier de préférence de polybutylène téréphtalate (PBT).

8. Serrure selon l'une quelconque des revendications 1 à 7, **caractérisée en ce que** les circuits imprimés (1) sont formés par une grille estampée.
